# EUROPEAN PATENT APPLICATION

(11) **EP 2 372 406 A1**
(43) Date of publication of application: **05.10.2011**
(21) Application number: 11158429.8
(22) Date of filing: 16.03.2011
(51) Int. Cl.: G02B 3/00, H01L 27/146

(54) **Lens array and lens array manufacturing method**

(30) Priority: 19.03.2010 JP 2010065215
(71) Applicant: Fujifilm Corporation, Minato-ku Tokyo 106-8620 (JP)
(72) Inventor: Sakaki, Takeshi, Saitama (JP); Fujiwara, Takayuki, Saitama (JP)
(74) Representative: HOFFMANN EITLE

(57) **Abstract**

A lens array and a lens array manufacturing method, and a lens and a lens manufacturing method are provided that are capable of suppressing the degradation in optical performance by suppressing the occurrence of the deformation or the peeling of a diaphragm member due to the high temperature in the reflow process.

A lens array has: a substrate (1) including a plurality of lens sections (10); and a diaphragm member (20) bonded to the surface of the substrate with a heat-resistant bonding layer (18) in between, and formed in an area other than the lens sections or an area overlapping part of the lens sections. The diaphragm member is a heat-resistant resin.

## Description

### BACKGROUND

### 1. Technical Field

The present invention relates to a lens array and a lens array manufacturing method. And, the present invention relates to a lens and a lens manufacturing method.

### 2. Related Art

Electronic apparatuses such as mobile telephones and PDAs (personal digital assistants) are provided with an image sensing unit. The image sensing unit is generally provided with: a solid-state image sensing device such as a CCD (charge coupled device) image sensor or a CMOS (complementary metal-oxide semiconductor) image sensor; and a lens for forming a subject image on the solid-state image sensing device. As a procedure of manufacturing such a lens, a method is available in which a lens array including a plurality of lens sections arranged on a substrate is integrally molded of a molding resin and the lens array is divided into the individual lens sections to thereby obtain the lens.

Moreover, a method has been proposed in which for the purpose of reducing the manufacturing cost of the image sensing unit and simplifying the assembly process, a light intercepting member serving as the diaphragm of the lens sections is previously formed on the surface of the lens array when the lens array is manufactured.

Patent Reference 1 (JP-U-62-164617) describes the structure of an objective lens having a diaphragm formed by serigraphy or by bonding a seal-form member.

### SUMMARY

When an image sensing unit is mounted on an electronic apparatus, a reflow process such as soldering is performed. For this reason, it is necessary to select a material capable of resisting the heat (240°C) of a reflow furnace for the lens array used as the lens of the image sensing unit and for the light intercepting member previously formed on the lens array. Therefore, as the molding material for molding the lens array, a heat or light hardening resin capable of resisting the high temperature of the reflow process is used, and as the material for the light intercepting member formed on the lens array, a metal with high heat resistance is used. However, generally, the linear expansion coefficient is significantly different between the light intercepting member made of a metal and the resin forming the lens array. Consequently, a difference in thermal expansion coefficient is caused therebetween as the temperature changes in the reflow process or the like, and this results in distortion. It is feared that this causes deformation or peeling of the light intercepting member to degrade optical performance. In addition, the metal evaporated film forming the light intercepting member is costly to form.

Patent Reference 1 is not intended to solve the problem in that the high temperature of the reflow furnace causes deformation or peeling of the light intercepting member, and has no description as to the material of the diaphragm.

An object of the present invention is to provide a lens array and a lens array manufacturing method, and a lens and a lens manufacturing method capable of suppressing the degradation in optical performance caused by the deformation or the peeling of the diaphragm member due to the high temperature in the reflow process.

According to an aspect of the invention, a lens array includes: a substrate including a plurality of lens sections; and a diaphragm member bonded to a surface of the substrate with a heat-resistant bonding layer in between, and formed in an area other than the lens sections or an area overlapping part of the lens sections. The diaphragm member is a heat-resistant resin.

According to another aspect of the invention, a lens includes: a substrate piece including one lens section; and a diaphragm member bonded to a surface of the substrate piece with a heat-resistant bonding layer in between and formed in an area other than the lens section or an area overlapping part of the lens section. The diaphragm member is a heat-resistant resin.

According to another aspect of the invention, a lens array manufacturing method includes: molding a lens array having a substrate including a plurality of lens sections; forming, of a heat-resistant resin, a diaphragm member where openings corresponding to the lens sections are formed in accordance with an arrangement of the plurality of lens sections; and bonding the diaphragm member to an area, other than the lens sections, of a surface of the substrate or an area overlapping part of the lens sections on the molded lens array, with a heat-resistant bonding layer in between.

According to another aspect of the invention, a lens manufacturing method includes: molding a lens array having a substrate including a plurality of lens sections; forming, of a heat-resistant resin, a diaphragm member where openings corresponding to the lens sections are formed in accordance with an arrangement of the plurality of lens sections; bonding the diaphragm member to an area, other than the lens sections, of a surface of the substrate or an area overlapping part of the lens sections on the molded lens array, with a heat-resistant bonding layer in between; and forming a lens where a divisional substrate piece has one lens section, by dividing the substrate into pieces each including one lens section.

With the configuration of any one of aspects of the invention, forming the diaphragm member by a heat-resistant resin suppresses the difference in thermal expansion coefficient between the resin of the diaphragm member and the resin forming the lens array and/or lens. Therefore, when an image sensing unit such as the manufactured lens array and lens is mounted on an electronic apparatus using a reflow process, it is possible to suppress the degradation in optical performance caused by the deformation or the peeling of the diaphragm member due to the high temperature of the reflow furnace.

### BRIEF DESCRIPTION OF THE DRAWINGS

FIG 1 is an exploded perspective view of a lens array.
FIG. 2 is a cross-sectional view of the lens array.
FIG. 3 is a cross-sectional view of a lens.
FIG. 4 is a cross-sectional view of an image sensing unit.
FIGS. 5A to 5C are views showing the procedure of molding a resin mold forming the lens array.
FIGS. 6A and 6B are views showing the procedure of processing a diaphragm member.
FIG. 7 is a view showing a condition before the resin mold and the diaphragm member are bonded together.
FIG. 8 is a view showing the manufactured lens array.
FIG. 9 is a view showing a condition where the lens array is diced.
FIG. 10 is a view showing a condition where the lens array and a wafer are bonded together.
FIG. 11 is a view showing a condition where the lens array shown in FIG. 10 is diced.

### DETAILED DESCRIPTION

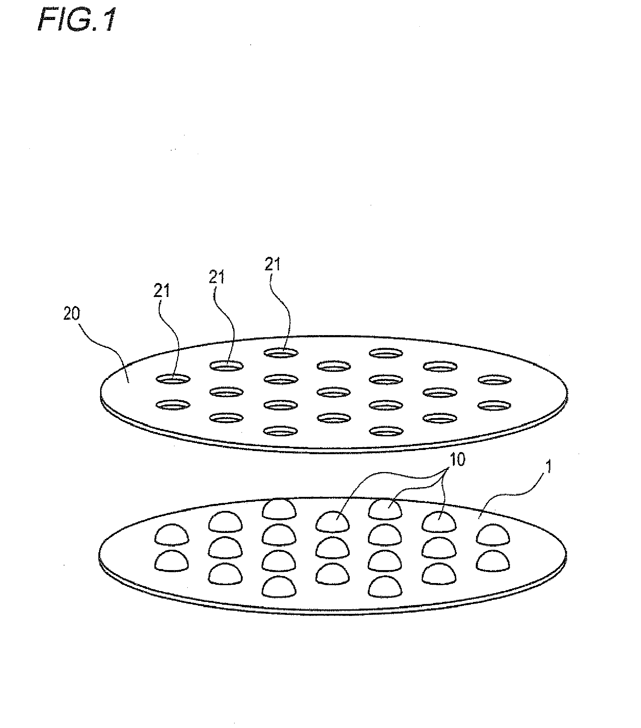

FIG. 1 is an exploded perspective view of a lens array.

The lens array has a substrate 1 including a plurality of lens sections 10. The lens sections 10 are arranged on the surface of the substrate 1. The lens array also has a diaphragm member 20 bonded to the part of the surface of the substrate 1 where the lens sections 10 are not formed, with a non-illustrated bonding layer in between.

The lens array is obtained by molding a molding material by use of a molding die and hardening it. That is, the lens sections 10 are made of the same material as the substrate 1, and molded integrally with the substrate 1.

In the diaphragm member 20, a plurality of openings 21 having a diameter substantially equal to that of the lens sections 10 are formed in accordance with the arrangement of the lens sections 10 on the substrate 1.

The diaphragm member 20 functions as a flare stop for intercepting stray light when it has a structure in which the openings 21 are formed so as not to overlap the lens surfaces of the lens sections 10.

Alternatively, part of the diaphragm member 20 may overlap part of the lens surfaces of the lens sections 10. At this time, the diameter of the openings 21 of the diaphragm member 20 corresponds to the effective diameter of the lens sections 10. That is, the diaphragm member 20 functions as an aperture stop that restricts the amount of bundle of rays passing through the lens sections 10.

The diaphragm member 20 is made of a heat-resistant resin. A concrete material and a manufacturing method for the diaphragm member 20 will be described later.

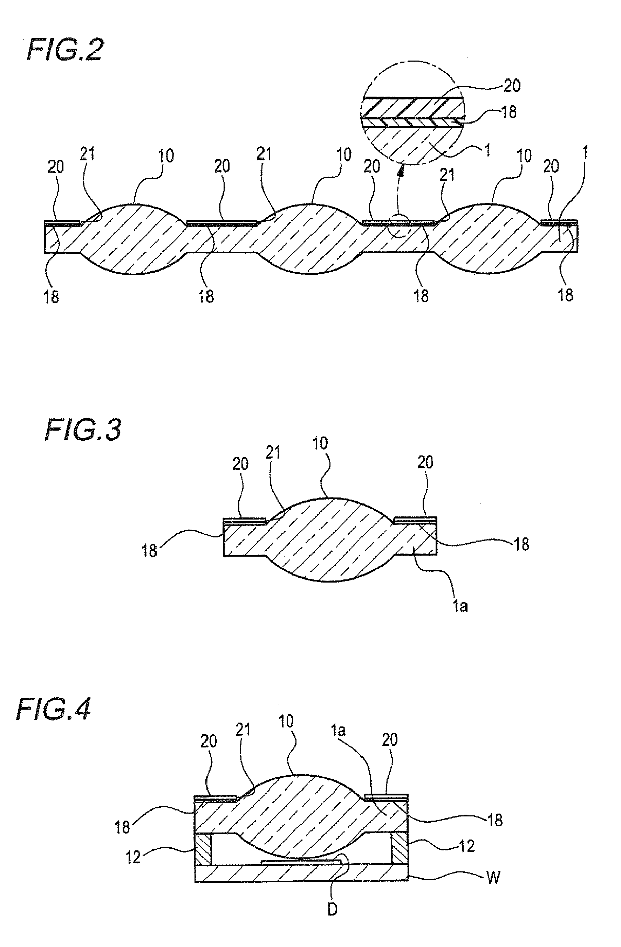

FIG. 2 is a cross-sectional view showing part of the lens array. The lens sections 10 include lens surfaces paired with each other on both surfaces of the substrate 1, and has a concave lens shape where the lens surfaces have convex surfaces protruding from the flat part of the substrate 1. The shape of the lens sections 10 is not specifically limited and may be changed as appropriate according to use or the like.

The lens array has the diaphragm member 20 bonded to the part of the surface of the substrate 1 where the lens sections 10 are not formed, with a heat-resistant bonding layer 18 in between. That is, the part of the lens array other than the lens sections 10 has a three-layer structure consisting of the substrate 1, the bonding layer 18 and the diaphragm member 20.

FIG. 3 is a cross-sectional view of the lens.

The lens has a substrate piece 1a including one lens section 10. The substrate piece 1a is a piece into which the substrate 1 of the lens array is divided so as to include one lens section 10, and is made of the same material as the substrate 1. Therefore, in the following description, this will be described as the substrate piece 1a in the lens structure:
The lens has the diaphragm member 20 bonded, with the bonding layer 18 in between, to the part of the surface of the substrate piece 1a where the lens section 10 is not formed. That is, the part of the lens other than the lens section 10 has a three-layer structure consisting of the substrate piece 1a, the bonding layer 18 and the diaphragm member 20.

FIG. 4 is a cross-sectional view of an image sensing unit.

The image sensing unit has a lens module and a sensor module.

The lens module includes the lens shown in FIG. 3 and a spacer 12 bonded to the substrate piece 1a of the lens to maintain the interval between the lens and the sensor module.

The sensor module includes a wafer W and an image sensing device D provided on the wafer W. The wafer W is formed by cutting a material made of a semiconductor material such as a silicon, in a shape substantially rectangular when viewed two-dimensionally. The image sensing device D is provided substantially in the center of the wafer W. The image sensing device D is, for example, a CCD image sensor or a CMOS image sensor. The sensor module may have a structure in which the image sensing device D constructed in chip form is bonded onto a wafer where wiring and the like are formed. Alternatively, the image sensing device D may be constructed by repetitively performing a known film formation process, photolithography process, etching process, impurity addition process and the like on the wafer W and forming an electrode, an insulating film, wiring and the like on the wafer W.

The lens section 10 of the image sensing unit forms a subject image on the image sensing device D provided on the sensor module side.

The substrate piece 1a of the lens and the wafer W of the sensor module have substantially the same rectangular shape when viewed two-dimensionally.

In the image sensing unit, the substrate piece 1a of the lens is overlaid on the wafer W of the sensor module with the spacer 12 in between. The spacer 12 and the wafer W are bonded together, for example, by using a bonding agent.

The spacer 12 is designed so that the lens section 10 forms a subject image on the image sensing device D of the sensor module, and is formed in a thickness that separates the lens section 10 and the image sensing device D by a predetermined distance so that the lens section 10 is not in contact with the sensor module.

The shape of the spacer 12 is not specifically limited and may be changed as appropriate as long as the positional relationship can be maintained in which the substrate piece 1a and the wafer W are separated from each other by a predetermined distance. For example, the spacer 12 may be a member having a lattice shape when the substrate piece 1a is viewed two-dimensionally, or may be a plurality of columnar members arranged around the lens section 10. Moreover, the spacer 12 may be a frame member that surrounds the image sensing device D. By isolating the image sensing device D from the outside by surrounding it with the frame-form spacer 12, light other than the light passing through the lens can be intercepted so as not to be incident on the image sensing device D. Moreover, with a structure in which the image sensing device D is enclosed with the lens and the spacer 12, dust can be prevented from adhering to the image sensing device D.

The spacer 12 may be formed integrally with the substrate piece 1a.

The image sensing unit is reflow-mounted on a non-illustrated circuit board incorporated in a mobile terminal or the like. On the circuit board, paste-form solder is previously printed as appropriate in the position where the image sensing unit is mounted, the image sensing unit is placed thereon, and heating such as infrared radiation or hot air blowing is performed on the circuit board containing the image sensing unit to thereby weld the image sensing unit to the circuit board.

As a modification of the lens structure, a plurality of substrate pieces 1a where the lens sections 10 are formed may be overlaid one on another. At this time, the substrate pieces overlaid one on another are assembled through spacers.

As a modification of the image sensing unit, a sensor module may be bonded through the spacer 12 to the substrate piece 1a in the lowest position of a lens lamination having a plurality of substrate pieces 1a where the lens sections 10 are formed.

Next, the molding material used for molding the lens array will be described.

As the molding material, a resin is used that has fluidity at the time of molding and is hardened by heating or light irradiation after molding. Such a resin may be either a heat hardening resin or a resin hardened by the irradiation of active energy rays (for example, ultraviolet rays).

It is desirable that the resin as the molding material have moderate fluidity before hardened from the viewpoint of moldability such as the die shape transfer suitability at the time of molding. Specifically, it is desirable that the resin be liquid at normal temperature and has a viscosity of approximately 1000 to 50000 mPa · s.

On the other hand, it is desirable that the resin as the molding material have heat resistance to the extent that it does not thermally deform even when undergoing the reflow process after hardened. From this viewpoint, the glass transition temperature of the hardened resin is desirably, not less than 250°C and particularly desirably, not less than 300°C. To provide the resin composition with such a high heat resistance, it is necessary to bind the mobility at the molecular level, and examples of effective means include: (1) means for increasing the crosslink density per unit volume; (2) means using a resin having a rigid ring structure (for example, a resin having an alicyclic ring structure such as cyclohexane, norbornane or tetracyclododecane, an aromatic ring structure such as benzene or naphthalene, a cardo structure such as 9,9'-biphenylfluorene, or a spiro structure such as spirobiindane, specifically, a resin described, for example, in JP-A-09-137043, JP-A-10-67970, JP-A-2003-55316, JP-A-2007-334018 or JP-A-2007-238883); and (3) means for uniformly dispersing a high Tg material such as inorganic particles (described, for example, in JP-A-05-209027, JP-A-10-298265). A plurality of these means may be used in combination, and it is desirable to make adjustment within the bounds of not impairing other properties such as the fluidity, the shrinkage rate and the refractive index characteristics.

From the viewpoint of the shape transfer precision, it is desirable that the composition of the resin as the molding material be low in the rate of the volume shrinkage due to the hardening reaction. The hardening shrinkage rate of the resin is, desirably, not more than 10%, more desirably, not more than 5%, and particularly desirably, not more than 3%.

Examples of the resin composition with a low hardening shrinkage rate include: (1) a resin composition containing a high molecular weight hardening agent (prepolymer, etc.) (described, for example, in JP-A-2001-19740, JP-A-2004-302293 and JP-A-2007-211247. The number average molecular weight of the high molecular weight hardening agent is, desirably, in a range of 200 to 100,000, more desirably, in a range of 500 to 50,000, and particularly desirably, in a range of 1,000 to 20,000. Moreover, a value calculated by (the number average molecular weight of the hardening agent)/(the number of hardening reactive groups) is, desirably, in a range of 50 to 10,000, more desirably, in a range of 100 to 5,000, and particularly desirably, in a range of 200 to 3,000); (2) a resin composition containing a nonreactive material (organic/inorganic particles, nonreactive resin, etc.) (described, for example, in JP-A-06-298883, JP-A-2001-247793 and JP-A-2006-225434); (3) a resin composition containing a low shrinkage cross-linking reactive group (for example, a ring-opening polymerizable group [for example, an epoxy group (described, for example, in JP-A-2004-210932), an oxetanyl group (described, for example, in JP-A-08-134405), an episulfide group (described, for example, in JP-A-2002-105110), a cyclic carbonate group (described, for example, in JP-A-07-62065)], an enethiol hardening group (described, for example, in JP-A-2003-20334), and a hydrosilylation hardening group (described, for example, in JP-A-2005-15666)); (4) a resin composition containing a rigid skeleton resin (fluorene, adamantane, isophorone, etc.) (described, for example, in JP-A-09-137043); (5) a resin composition containing two kinds of monomers of different polymerizable groups and in which an inter penetrating network structure (so-called IPN structure) is formed (described, for example, in JP-A-2006-131868); and (6) a resin composition containing an expandable substance (described, for example, in JP-A-2004-2719 and JP-A-2008-238417). These can be suitably used in the present invention. From the viewpoint of property optimization, it is desirable to use a plurality of above-mentioned hardening shrinkage reduction means in combination (for example, a prepolymer containing a ring-opening polymerizable group and a resin composition containing particles).

For the lens array, a resin having two or more kinds of high and low different Abbe numbers is desirable.

The Abbe number (vd) of the high Abbe number side resin is, desirably, not less than 50, more desirably, not less than 55, and particularly desirably, not less than 60. The refractive index (nd) is, desirably, not less than 1.52, more desirably, not less than 1.55, and particularly desirably, not less than 1.57. As such a resin, an aliphatic resin is desirable, and particularly, a resin is desirable having an alicyclic structure (for example, a resin having a ring structure such as cyclohexane, norbornane, adamantane, tricyclodecane or tetracyclodecane, specifically, a resin described, for example, in JP-A-10-152551, JP-A-2002-212500, JP-A-2003-20334, JP-A-2004-210932, JP-A-2006-199790, JP-A-2007-2I44, JP-A-2007-284650 or JP-A-2008-105999),

The Abbe number (vd) of the low Abbe number side resin is, desirably, not more than 30, more desirably, not more than 25, and particularly desirably, not more than 20. The refractive index (nd) is, desirably, not less than 1.60, more desirably, not less than 1.63, and particularly desirably, not less than 1.65.

As such a resin, a resin having an aromatic structure is desirable. For example, a resin is desirable containing a structure of 9,9'-diarylfluorene, naphthalene, benzothiazole, benzotriazole or the like (specifically, a resin described, for example, in JP-A-60-38411, JP-A-10-67977, JP-A-2002-47335, JP-A-2003-238884, JP-A-2004-83855, JP-A-2005-325331 or JP-A-2007-238883, WO-A-2006/095610, or JP-B-2537540).

It is desirable that in the resin as the molding material, inorganic particles be dispersed in the matrix for the purposes of increasing the refractive index and adjusting the Abbe number. Examples of the inorganic particles include oxide particles, sulfide particles, selenide particles and telluride particles. More specifically, examples include particles of zirconium oxide, titanium oxide, zinc oxide, tin oxide, niobium oxide, cerium oxide, aluminum oxide, lanthanum oxide, yttrium oxide and zinc sulfide.

In particular, in the high Abbe number resin, it is desirable to disperse particles of lanthanum oxide, aluminum oxide, zirconium oxide or the like, and in the low Abbe number resin, it is desirable to disperse particles of titanium oxide, tin oxide, zirconium oxide or the like. As the inorganic particles, one kind may be used, or two or more kinds may be used in combination. The inorganic particles may be a compound of a plurality of ingredients.

Moreover, in the inorganic particles, for various purposes such as photocatalytic activity reduction and water absorption ratio reduction, a different kind of metal may be doped, the surface layer may be covered with a different kind of metal oxide such as silica or alumina, and the surface may be decorated with a silane coupling agent, a titanate coupling agent, a dispersing agent having an organic acid (carboxylic acids, sulfonic acids, phosphoric acids, phosphonic acids, etc.) or an organic acid group, or the like. The number average particle size of the inorcanic particles is normally set to approximately 1 nm to 1000 nm; however, if it is too small, there are cases where the property of the substance changes and if it is too large, the influence of the Rayleigh scattering is significant. Therefore, the number average particle size is, desirably, 1 nm to 15 nm, more desirably, 2 nm to 10 nm, and particularly desirably, 3 nm to 7 nm. Moreover, the narrower the particle size distribution of the inorganic particles, the more desirable. While such monodisperse particles are defined variously, for example, the numerical value definition range as described in JP-A-2006-160992 applies to a desirable particle diameter range. The number average primary particle size can be measured, for example, with an X-ray diffractometer (XRD) or a transmission electron microscope (TEM). When the temperature is 22°C and the wavelength is 589 nm, the refractive index of the inorganic particles is, desirably, 1.90 to 3.00, more desirably, 1.90 to 2.70, and particularly desirably, 2.00 to 2.70. From the viewpoint of transparency and refractive index enhancement, the inorganic particle content in the resin is, desirably, not less than 5% by mass, more desirably, 10 to 70% by mass, and particularly desirably, 30 to 60% by mass.

To uniformly disperse the particles into the resin as the molding material, it is desirable to disperse the particles by appropriately using, for example, a dispersing agent containing a functional group having reactivity to the resin monomer forming the matrix (described, for example, in embodiments of JP-A-2007-238884), a block copolymer formed of a hydrophobic segment and a hydrophilic segment (described, for example, in JP-A-2007-211164), a resin having a functional group capable of forming a given chemical union with the inorganic particles at an end of a high polymer or at a side chain (described, for example, in JP-A-2007-238929 and JP-A-2007-238930), or the like.

In the resin as the molding material, an additive agent such as a known mold releasing agent such as silicon series, fluorine series or a compound containing a long-chain alkyl group, or an antioxidant such as hindered phenol may be mixed as appropriate.

In the resin as the molding material, a hardening catalyst or an initiator may be mixed as required. A concrete example is a compound that accelerates the hardening reaction (radical polymerization or ionic polymerization) by heat or by the action of active energy rays which compound is described, for example, in JP-A-2005-92099 (paragraphs [0063] to [0070]). Although the additive amount of these hardening reaction accelerators differs according to the kind of the catalyst or the initiator, the difference in hardening reactive part or the like and cannot be defined indiscriminately, generally, it is desirably approximately 0.1 to 15% by mass, more desirably, approximately 0.5 to 5% by mass with respect to all the solids of the hardening reactive resin composition.

In a case where a different ingredient can be dissolved in a liquid low molecular monomer (reactive diluent) or the like when the above-mentioned ingredient is mixed as appropriate in the resin as the molding material at the time of manufacture, it is unnecessary to add a solvent separately. However, in other cases, the ingredients are dissolved in the resin by using a solvent separately at the time of manufacture. The solvent is not specifically limited and may be selected as appropriate as long as it is uniformly dissolved or dispersed without the composition of the resin being precipitated. Concrete examples include ketones (for example, acetone, methyl ethyl keton, methyl isobutyl ketone), esters (for example, ethyl acetate, butyl acetate), ethers (for example, tetra hydro furan, 1,4-dioxan), alcohols (for example, methanol, ethanol, isopropyl alcohol, butanol, ethylene glycol), aromatic hydrocarbons (for example, toluene, xylene) and water. When the resin contains a solvent, it is desirable to perform an operation of casting the resin on the substrate and/or the die member, drying the solvent and then, transferring the die shape.

Examples of the resin desirable as the molding material include, as the ultraviolet hardening resin, epoxy resin (linear expansion coefficient: 4.0×10⁻⁵/°C to 8.0×10⁻⁵/°C) and acrylic resin (linear expansion coefficient: 2.0×10⁻⁵/°C to 6.0×10⁻⁵/°C).

Examples of the heat hardening resin include silicone resin (linear expansion coefficient: 3 to 16 (10⁻⁵/°C), epoxy resin (linear expansion coefficient: 4 to 8 (10⁻⁵/°C) and phenol resin (linear expansion coefficient: 3 to 7 (10⁻⁵/°C). Concrete examples of such resins include SMX-7852 manufactured by Fuji Polymer Industries Co., Ltd., IVSM-4500 manufactured by Toshiba Corporation and SR-7010 manufactured by Dow Coming Toray Co., Ltd.

Next, the resin forming the diaphragm member will be described.

The resin forming the diaphragm member is a resin having heat resistance. As the resin having heat resistance, a material that resists the heat of the reflow furnace is selected.

Common examples of resins having heat resistance are engineering resins and super engineering resins.

Examples of engineering resins include polyamide (PA), polyacetal (POM), polycarbonate (PC), denatured polyphenylene ether (m-PPE), polybutylene terephthalate (PBT), GF-reinforced polyethylene terephthalate (GF-PET) and ultra high molecular weight polyethylene (UHPE).

Examples of super engineering resins include polyphenylene sulfide (PPS), polyimide (PI), polyether imide (PEI), polyarylate (PAR), polysulfone (PSF), polyether sulfone (PES), polyether ether ketone (PEEK), liquid crystal polymer (LCP) and polytetrafluoroethylene (PTFE).

The resin having heat resistance has a glass transition temperature of not less than 250°C.

Moreover, it is desirable that the resin having heat resistance have a linear expansion coefficient equal to or close to that of the resin as the molding material of the lens.

As the resin as the molding material of the lens and the resin forming the diaphragm member, it is desirable to use resins the linear expansion coefficient difference between which is not more than 1×10⁻⁵/°C.

As such a resin having heat resistance, for example, the following are suitable: polyamide imide (product name "TORLON (trademark)"), polyether ether ketone (product name "polypenco PEEK (trademark)" and reinforced polyamide imide (product name "Semitron (trademark)") manufactured by Nippon Polypenco Limited.

It is desirable that the difference in linear expansion coefficient between the lens array molding resin and the resin of the diaphragm member be not more than 1 × 10⁻⁵/°C. With this, when the lens array is used as the lens of the image sensing unit, the occurrence of deformation or peeling of the diaphragm member can be more reliably suppressed even though the diaphragm member is subjected to the high temperature of the reflow furnace.

For the heat-resistant bonding layer, a heat-resistant bonding agent may be used as the material. For example, a two-part epoxy bonding agent is used having a heat resistance with a glass transition temperature of not less than 250°C.

Next, the procedure of manufacturing the lens array and the lens will be described.

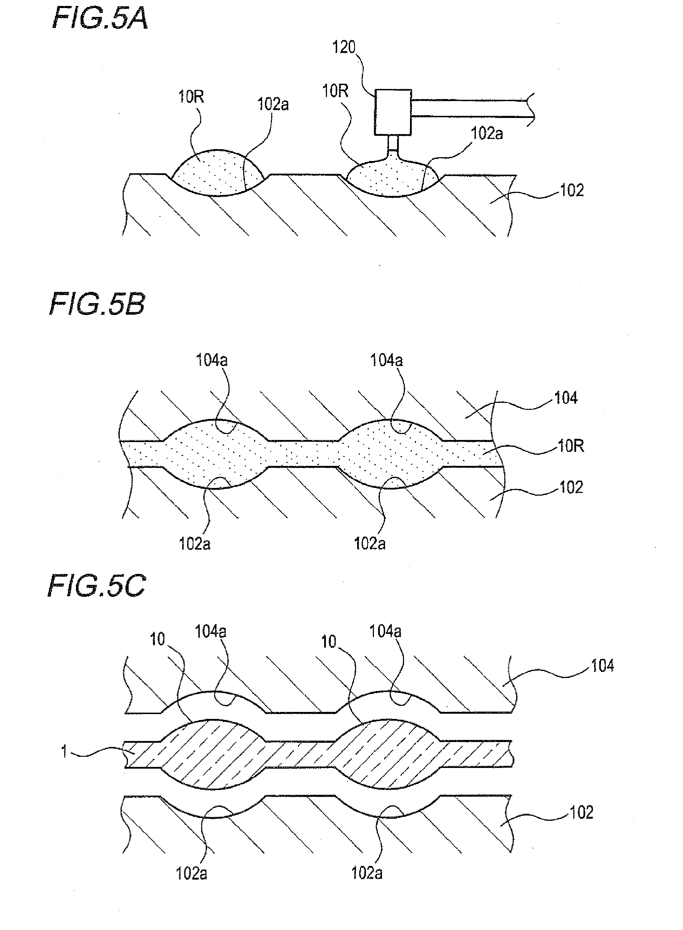

FIGS. 5A to 5C are views showing the procedure of molding the lens array.

As shown in FIG. 5A, a resin 10R as the molding material is supplied onto the die surface of a die member 102. On the die surface of the die member 102, lens transfer surfaces 102a having a reverse shape of the lens sections 10 are formed.

The resin 10R is supplied to the die surface of the die member 102 in a predetermined amount by a dispenser 120. As for the positions where the resin 10R is supplied, the resin 10R is supplied to each position of the lens transfer surface 102a.

After the resin 10R is supplied, as shown in FIG. 5B, the resin 10R supplied to the die member 102 is sandwiched by a die member 104. The die members 102 and 104 are formed of a pair of upper and lower dies. By the resin 10R being sandwiched between the pair of die members 102 and 104, the shape of a lens transfer surface 104a of the die surfaces of the die members 102 and 104 is transferred to the resin 10R.

Then, the resin 10R is hardened in a state of being sandwiched between the pair of die members 102 and 104.

When the resin 10R is an ultraviolet hardening resin, the resin 10R is hardened by applying ultraviolet rays to the resin 10R while maintaining the positions of the pair of die members 102 and 104. At this time, the one, on the side where ultraviolet rays are applied, of the pair of die members 102 and 104 is made of a transparent material through which ultraviolet rays can pass.

When the resin 10R is a heat hardening resin, the resin 10R is hardened by heating it with heating means such as a heater while maintaining the positions of the pair of die members 102 and 104.

After the resin 10R is hardened, as shown in FIG. 5C, the resin mold is released from each of the pair of die members 102 and 104. By doing this, a resin mold where a plurality of lens sections 10 are arranged on the substrate 1 can be obtained.

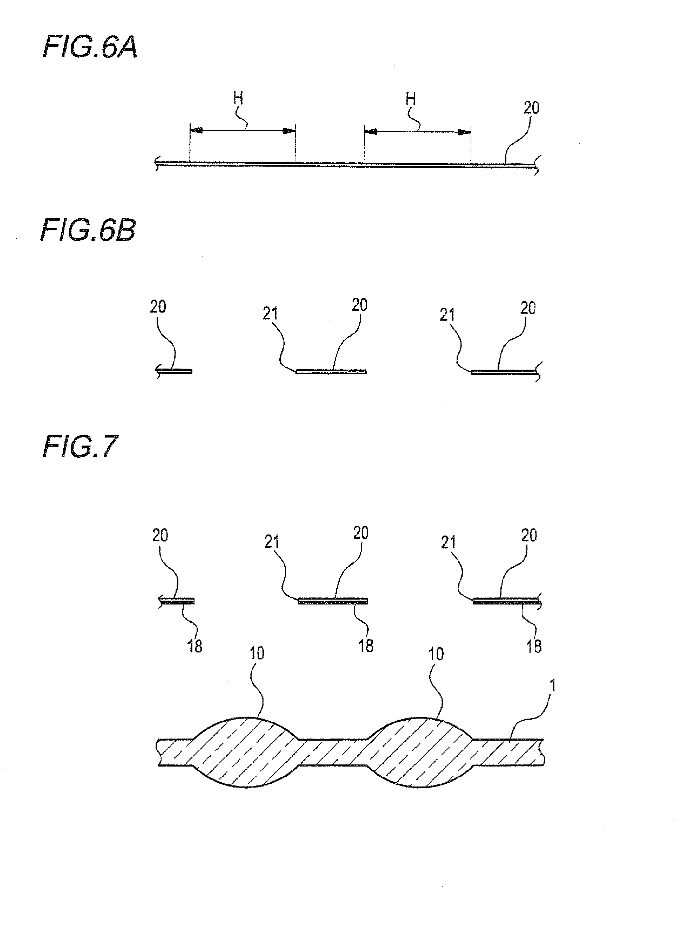

FIGS. 6A and 6B are views showing the procedure of processing the diaphragm member.

As shown in FIG. 6A, a resin member forming the diaphragm member is prepared. The resin member is a thin layer member. Areas H, on the resin member, corresponding to the positions of the lens sections 10 arranged on the lens array are punched by machining such as punching. By doing this, as shown in FIG. 6B, the diaphragm member 20 is obtained where a plurality of openings 21 corresponding to the lens sections 10 are formed in accordance with the arrangement of the lens sections.

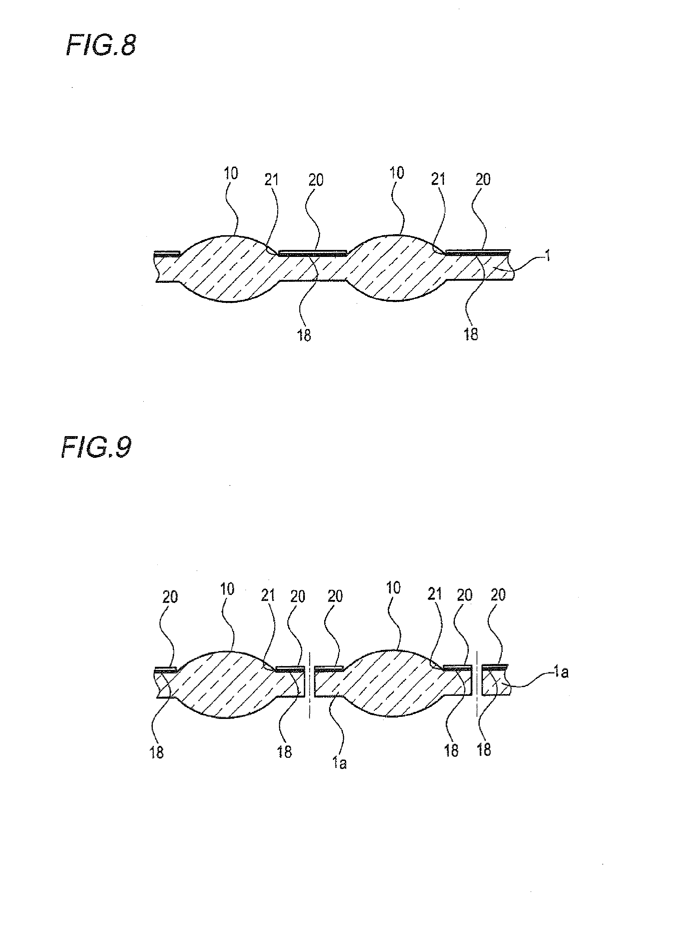

FIG. 7 is a view showing a condition before the resin mold and the diaphragm member are bonded together. FIG. 8 is a view showing a condition where the resin mold and the diaphragm member are bonded together.

The bonding layer 18 is formed on the bonded surface of the diaphragm member 20. Then, the diaphragm member 20 is bonded to the surface of the substrate 1 of the resin mold with the bonding layer 18 in between. The diaphragm member 20 is bonded to the area, of the surface of the substrate 1, other than the lens sections 10 or the area overlapping part of the lens sections 10. At this time, the centers of the openings 21 of the diaphragm member 20 and the centers of the lens sections 10 are made to coincide with each other.

The diaphragm member 20 may be bonded after the bonding layer 18 is formed on the surface of the substrate 1 of the resin mold.

FIG. 9 is a view showing a condition where the lens array is diced.

As shown in FIG. 9, the lens is obtained by manufacturing the lens array by the above-described procedure and then, dividing the substrate 1 into pieces each including one lens section 10.

Next, the procedure of manufacturing the image sensing unit will be described.

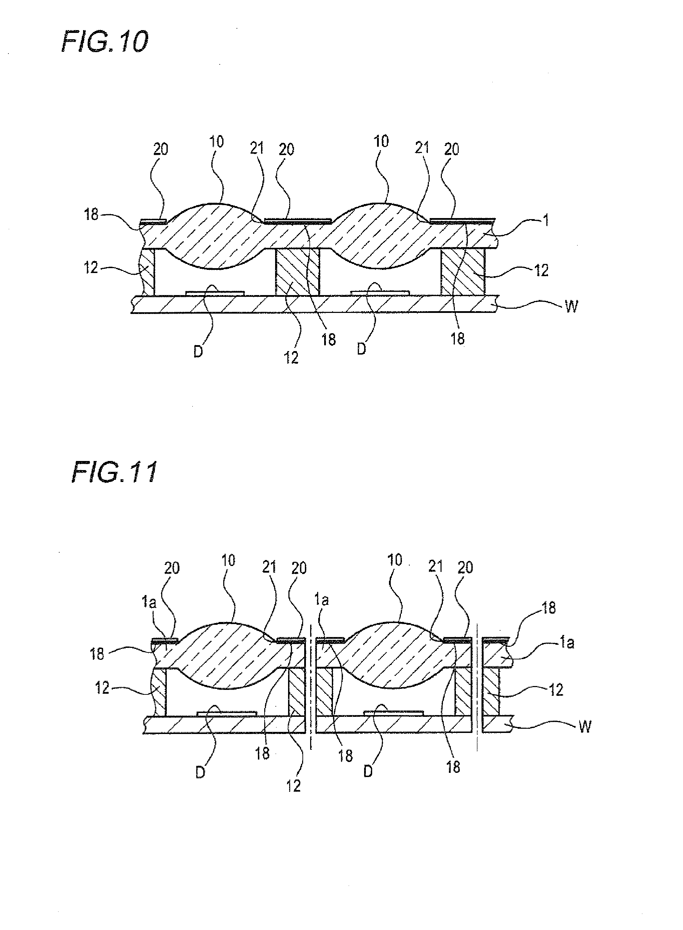

FIG. 10 is a view showing a condition where the lens array is bonded to a wafer.

The lens array is formed in advance by the above-described procedure. After the diaphragm member 20 is formed on the substrate 1 with the bonding layer 18 in between, the lens array is bonded to the wafer W with the spacer 12 in between.

FIG. 11 is a view showing a condition where the lens array and the wafer shown in FIG. 10 are diced. The lens array and the wafer are both diced in a state of being bonded together. At this time, the substrate 1 is separated into a plurality of substrate pieces 1a each including one lens section 10. The spacer 12 is formed so as to correspond to the diced area on the substrate 1 of the lens array, and is separated by the dicing so as to belong to each image sensing unit. By doing this, the image sensing unit can be obtained that has the image sensing device D, the lens and the diaphragm member 20 bonded to the surface of the substrate piece 1a of the lens by the bonding layer 18.

The description discloses the following lens array and lens and manufacturing method of the lens array and manufacturing method of the lens.
(1) A lens array includes: a substrate including a plurality of lens sections; and a diaphragm member bonded to a surface of the substrate with a heat-resistant bonding layer in between, and formed in an area other than the lens sections or an area overlapping part of the lens sections. The diaphragm member is a heat-resistant resin.
(2) The lens array of (1), glass transition temperatures of the resin and the bonding layer are not less than 250°C.
(3) The lens array of (1) or (2), the lens sections and the substrate are integrally molded of a molding resin. A difference in linear expansion coefficient between the molding resin and the resin of the diaphragm member is not more than 1×10⁻⁵/°C.
(4) A lens includes: a substrate piece including one lens section; and a diaphragm member bonded to a surface of the substrate piece with a heat-resistant bonding layer in between and formed in an area other than the lens section or an area overlapping part of the lens section. The diaphragm member is a heat-resistant resin.
(5) A lens array manufacturing method includes: molding a lens array having a substrate including a plurality of lens sections; forming, of a heat-resistant resin, a diaphragm member where openings corresponding to the lens sections are formed in accordance with an arrangement of the plurality of lens sections; and bonding the diaphragm member to an area, other than the lens sections, of a surface of the substrate or an area overlapping part of the lens sections on the molded lens array, with a heat-resistant bonding layer in between.
(6) A lens manufacturing method including: molding a lens array having a substrate including a plurality of lens sections; forming, of a heat-resistant resin, a diaphragm member where openings corresponding to the lens sections are formed in accordance with an arrangement of the plurality of lens sections; bonding the diaphragm member to an area, other than the lens sections, of a surface of the substrate or an area overlapping part of the lens sections on the molded lens array, with a heat-resistant bonding layer in between; and forming a lens where a divisional substrate piece has one lens section, by dividing the substrate into pieces each including one lens section.

## Claims

1. A lens array comprising:
a substrate including a plurality of lens sections; and
a diaphragm member bonded to a surface of the substrate with a heat-resistant bonding layer in between, and formed in an area other than the lens sections or an area overlapping part of the lens sections,
wherein the diaphragm member is a heat-resistant resin.

2. The lens array according to claim 1,
wherein glass transition temperatures of the resin and the bonding layer are not less than 250°C.

3. The lens array according to claim 1 or 2,
wherein the lens sections and the substrate are integrally molded of a molding resin, and
a difference in linear expansion coefficient between the molding resin and the resin of the diaphragm member is not more than 1×10⁻⁵/°C.

4. A lens array manufacturing method comprising:
molding a lens array having a substrate including a plurality of lens sections;
forming, of a heat-resistant resin, a diaphragm member where openings corresponding to the lens sections are formed in accordance with an arrangement of the plurality of lens sections; and
bonding the diaphragm member to an area, other than the lens sections, of a surface of the substrate or an area overlapping part of the lens sections on the molded lens array, with a heat-resistant bonding layer in between.
